# EUROPÄISCHE PATENTSCHRIFT

(11) **EP 1 696 487 B1**
(45) Veröffentlichungstag und Bekanntmachung des Hinweises auf die Patenterteilung: **18.06.2008**
(21) Anmeldenummer: 06003218.2
(22) Anmeldetag: 17.02.2006
(51) Int. Cl.: H01L 23/64

(54) **Hochfrequenzanordnung**
High frequency arrangement
Arrangement haute fréquence

(30) Priorität: 23.02.2005 DE 102005008195
(43) Veröffentlichungstag der Anmeldung: 30.08.2006
(73) Patentinhaber: ATMEL Germany GmbH, 74072 Heilbronn (DE)
(72) Erfinder: Bromberger, Christoph, Dipl.-Phys., 74074 Heilbronn (DE)
(74) Vertreter: Müller, Wolf-Christian

(56) Entgegenhaltungen:
- EP-A- 0 969 509
- WO-A-98/13873
- US-A- 5 534 727

## Beschreibung

Die Erfindung betrifft eine Hochfrequenzanordnung.

Mit steigender Betriebsfrequenz von Hochfrequenzschaltkreisen übt die Montagetechnik, also die elektrische und mechanische Verbindung eines Halbleiterplättchens mit seinem Gehäuse und den Anschlüssen oder mit weiteren Halbleiterplättchen, einen steigenden Einfluss auf die Funktionalität des Hochfrequenzschaltkreises aus. Die elektrischen und mechanischen Verbindungen verursachen parasitäre Induktivitäten und Kapazitäten, die elektrische Eigenschaften des Hochfrequenzschaltkreises verschlechtern können.

Einen möglichen Grund für diese Verschlechterung bilden die Induktivitäten der zur Verbindung des Hochfrequenzschaltkreises benötigten Zuleitungen, wie Bonddrähte oder Lötbumps oder dergleichen.

Eine bekannte Lösung für dieses Problem besteht in der Verwendung einer so genannten "virtuellen Masse". Anstelle beispielsweise einer so genannten "single ended"-Verstärkeranordnung (nicht-symmetrisch) verwendet man ein differentielles Verstärkerdesign, bei welchem der Symmetriepunkt der Verstärkerschaltung keine Spannungsschwankungen erfährt. Bei einer Versorgung der Verstärkerschaltung aus dem Symmetriepunkt können hiernach Zuleitungsinduktivitäten bei entsprechendem Schaltungsdesign außer Acht bleiben.

Verbunden mit der symmetrischen Lösung ist, Lasten symmetrisch treiben zu müssen, oder das zunächst differentiell vorliegende Ausgangssignal zu asymmetrisieren. Der messtechnische Aufwand zur Erfassung der elektrischen Kenngrößen muss an das differentielle System angepasst werden. Die Komplexität symmetrischer Systeme ist gegenüber nichtsymmetrischen Systemen erhöht.

Um unerwünschte Resonanzkreise durch Zuleitungen zu externen Kondensatoren mit den Problemen von Instabilität und geringer Bandbreite zu vermeiden wird in der WO 98/13873 A1 offenbart, offenbart einen Leistungsbipolartransistor für MW oder RF-Anwendungen auszubilden. Dazu sind zwei Emitterkontakte vorgesehen, wobei ein erster Emitterkontakt mit einem Widerstand und ein zweiter Emitterkontakt mit einem mehrschichtigen Kondensator verbunden sind. Der Kondensator wird auf einem Glas-/Siliziumsubstrat ausgebildet. Der Leistungsbipolartransistor ist hingegen in einem (separaten) Siliziumsubstrat ausgebildet. Der Leistungsbipolartransistor ist mittels Flip-Chip-Technik auf das Glas-/Siliziumsubstrat mit dem Kondensator gebondet. Der Widerstand und der Kondensator sind parallelgeschaltet.

Der Erfindung liegt die Aufgabe zu Grunde den Einfluss von Induktivitäten der Zuleitungen zum Hochfrequenzschaltkreis auf dessen elektrische Eigenschaften möglichst zu reduzieren.

Diese Aufgabe wird durch die unabhängigen Ansprüche gelöst. Vorteilhafte Weiterbildungen der Erfindung sind Gegenstand von Unteransprüchen.

Demgemäß ist eine Hochfrequenzanordnung vorgesehen, wie diese beispielsweise für einen Bereich größer 1 GHz verwendet wird. Die Hochfrequenzanordnung weist einen Hochfrequenzschattkreis auf einem Halbleiterplättchen und eine elektrische Zuleitung auf. Der Hochfrequenzschaltkreis ist durch die elektrische Zuleitung zum Halbleiterplättchen mit einem Gehäuseanschluss und/oder einem weiteren Schaltkreis verbunden. Die elektrische Zuleitung weist dabei eine gegebenenfalls parasitäre Induktivität auf. Die Zuleitung zum Halbleiterplättchen ist beispielsweise ein Bonddraht und/oder ein Lötbump.

Das Wesen der Erfindung besteht nun darin, dass der elektrischen Zuleitung ein Serienschwingkreis parallel geschaltet ist. Der Serienschwingkreis ist insbesondere gedämpft, indem beispielsweise dieser Serienschwingkreis selbst einen (reellen) Widerstandsanteil aufweist. Der Serienschwingkreis weist dabei eine Resonanzfrequenz auf, die an eine Anforderung des Hochfrequenzschaltkreises angepasst ist. Hierzu ist eine Resonanzfrequenz des Serienschwingkreises auf eine Betriebsfrequenz des Hochfrequenzschaltkreises abgestimmt. Eine bevorzugte Ausgestaltung der Erfindung sieht vor, dass der Serienschwingkreis durch eine als Induktivität wirkende Zuleitung und einen eine Kapazität aufweisenden Bondpad gebildet ist.

Ein weiterer Aspekt der Erfindung ist eine Hochfrequenzanordnung mit einem integrierten Hochfrequenzschaltkreis, einem ersten Bondpad und einer ersten elektrischen Zuleitung. Der Bondpad ist dabei über die erste elektrische Zuleitung, insbesondere einen Bonddraht und/oder einen Lötbump, mit einem Gehäuseanschluss und/oder einem weiteren Schaltkreis elektrisch verbunden. Als Gehäuse können dabei eine Vielzahl von Gehäusetypen, wie beispielsweise oberflächenmontierbare Gehäuse (SMD) oder Flip-Chip-Gehäuse verwendet werden.

Das erste Bondpad grenzt an ein Dielektrikum. Dabei bildet das erste Bondpad mit dem Dielektrikum und einem elektrisch leitfähigen Gebiet des integrierten Hochfrequenzschaltkreises eine erste Kapazität. Die Kapazität ist dabei von der Dicke des Dielektrikum und der Geometrie des Bondpads, sowie deren Toleranzen abhängig.

Die erste Kapazität und die, eine Induktivität aufweisende erste Zuleitung beeinflussen eine erste Resonanzfrequenz, die dem Hochfrequenzschaltkreis zugeordnet ist. Die Resonanzfrequenz ist im Rahmen üblicher Fertigungstoleranzen auf eine Betriebsfrequenz des Hochfrequenzschaltkreises abgestimmt.

In einer bevorzugten Weiterbildung der Erfindung ist ein zweites Bondpad mit dem elektrisch leitfähigen Gebiet leitfähig verbunden, so dass zwischen dem Bondpad und dem Hochfrequenzschaltkreis ein signifikanter Gleichstromanteil über das zweite Bondpad fließen kann. Zur Parallelschaltung mit dem ersten Bondpad und mit der ersten Zuleitung ist das zweite Bondpad über eine zweite Zuleitung mit dem Gehäuseanschluss und/oder dem weiteren Schaltkreis elektrischen verbunden.

Um insbesondere Fertigungstoleranzen der Geometrie des ersten Bondpads und einer Dicke des Dielektrikums auszugleichen, ist in einer vorteilhaften Weiterbildung der Erfindung ein drittes Bondpad vorgesehen, das zur Parallelschaltung über eine dritte Zuleitung mit dem Gehäuseanschluss und/oder dem weiteren Schaltkreis elektrischen verbunden ist. Vorzugsweise ist das dritte Bondpad dabei zu dem ersten Bondpad oder dem zweiten Bondpad benachbart angeordnet.

Das dritte Bondpad grenzt dabei an ein Dielektrikum. Dieses Dielektrikum ist dabei vorzugsweise aus derselben Materialzusammensetzung und im Rahmen der Fertigungstoleranz aus der gleichen Materialdicke wie das Dielektrikum, das an das erste Bondpad grenzt. Alternativ können auch abweichende Dielektrika verwendet werden. Das dritte Bondpad bildet mit dem Dielektrikum und dem elektrisch leitfähigen Gebiet des integrierten Hochfrequenzschaltkreises eine zweite Kapazität. Dabei beeinflussen die zweite Kapazität und die, eine Induktivität aufweisende zweite Zuleitung eine, dem Hochfrequenzschaltkreis zugeordnete zweite Resonanzfrequenz. Bevorzugt ist diese zweite Resonanzfrequenz von der ersten Resonanzfrequenz verschieden und weicht von dieser um weniger als 10%, besonders bevorzugt um weniger als 5% ab.

Die Erfindung bevorzugt weiterbildend beeinflussen weitere Parallelschaltungen von weiteren Leitungen und weiteren an Dielektrikum grenzende Bondpads weitere Resonanzfrequenzen. Vorteilhafterweise ist die Anzahl der Parallelschaltungen von der Fertigungstoleranz der Geometrie der Bondpads und der Dicke des Dielektrikums abhängig. Bevorzugt bilden die parallel geschalteten Einzelresonanzkreise zudem Koppelresonanzen aus, die durch die Verschaltung der Einzelresonanzkreise untereinander gebildet werden.

Eine bevorzugte Weiterbildung der Erfindung sieht vor, dass die erste Kapazität von der zweiten Kapazität durch eine unterschiedliche Geometrie, insbesondere durch einen abweichenden Flächeninhalt, verschieden ist. Werden eine Vielzahl von Zuleitungen zueinander parallel geschaltet, weist jede Kapazität bevorzugt eine von jeder beliebigen anderen Kapazität eines Serienschwingkreises abweichende Geometrie auf, so dass die einzelnen Resonanzkreise gegeneinander verstimmt sind.

Eine besonders vorteilhafte Weiterbildung der Erfindung gibt an, dass das leitfähige Gebiet mit einem Halbleitergebiet eines aktiven, integrierten Bauelementes des integrierten Hochfrequenzschaltkreises leitfähig verbunden ist. Das Halbleitergebiet ist beispielsweise ein Draingebiet eines Hochfrequenzfeldeffekttransistors. Besonders bevorzugt ist das Halbleitergebiet jedoch ein Emitter eines Hochfrequenzbipolartransistors oder einer Hochfrequenztetrode, der mit dem leitfähigen Gebiet leitfähig beispielsweise über ein Metallgebiet oder einen Materialübergang oder eine Grenzfläche zwischen verschiedenen Dotierstoffkonzentrationen verbunden ist.

Bevorzugt ist der Hochfrequenzschaltkreis derart ausgebildet, dass zumindest die zweite Leitung eine elektrische Gegenkopplung, insbesondere eine Stromgegenkopplung, für den integrierten Hochfrequenzschaltkreis bildet, die zumindest für die erste Resonanzfrequenz durch die Parallelschaltung mit dem ersten Bondpad und der ersten Leitung reduzierbar ist.

Die Erfindung vorteilhaft ausgestaltend ist vorgesehen, dass das Dielektrikum Siliziumdioxid aufweist und vorzugsweise eine Dicke kleiner 100nm, besonders bevorzugt jedoch eine Dicke von 50 nm aufweist.

Zwar ist es prinzipiell möglich, dass das leitfähige Gebiet, das an das Dielektrikum grenzt, einen dotierten Halbleiter aufweist, gemäß einer besonders vorteilhaften Ausgestaltung der Erfindung weist das leitfähige Gebiet jedoch ein Metall auf. Beispielsweise besteht das leitfähige Gebiet aus Aluminium oder einem Silizid.

Im Folgenden wird die Erfindung in Ausführungsbeispielen anhand zeichnerischer Darstellungen näher erläutert.

Dabei zeigen
- Fig. 1: eine Schnittansicht durch ein Anschlussgebiet eines Halbleiterplättchens,
- Fig. 2: ein Schaltplan für einen Hochfrequenzverstärker,
- Figuren 3a bis 3c: Beispiele verschiedene Emitterschaltungen, und
- Fig. 4: ein Verstärkungs-Frequenz-Diagramm.

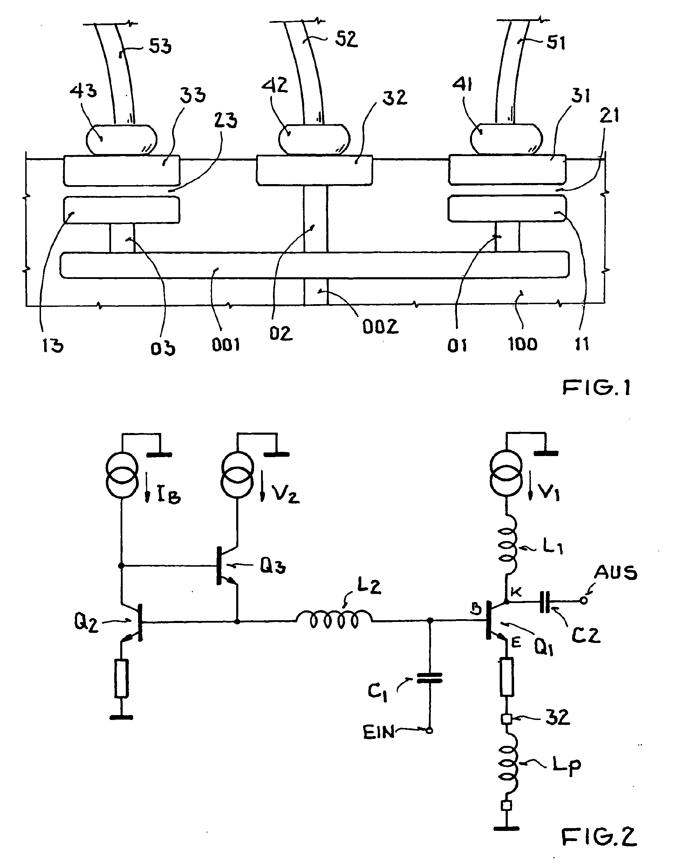

Zunächst wird für die Fig. 2 die erzielbare Leistungsverstärkung eines Ausgangstreibers für 5 GHz in SiGe-Technologie betrachtet. Als Ausgangstreiber dient hierbei ein SiGe-npn-Heterobipolartransistor Q1 mit einer Emittergröße von 20x1 µm² pro Emitterfinger und einer Anzahl NE von Emitterfingern, nachfolgend "Fingerzahl" genannt, in Emitterschaltung. Eine zur elektrischen Kontaktierung des Emitters E benötigte Zuleitung (Lp) lässt sich, gleich ob in Form von Lötbumps oder Bonddrähten, kaum mit einem reaktiven Anteil Lp von weniger als 0.1 nH ausführen.

Eine Parallelschaltung einer Anzahl n von nicht miteinander verkoppelten Induktivitäten Lp einer gegebenen Einzelinduktivität weist insgesamt eine Induktivität von der Größe der durch den Faktor n geteilten Einzelinduktivität auf. Umgekehrt erfährt entsprechend jeder von NE in ihrer Gesamtheit mit einer Induktivität von 0.1 nH angeschlossenen Emitterfingern eine effektive Induktivität vom NE-fachen von 0.1 nH.

Eine Induktivität Lp im Emitterzweig stellt jedoch eine Gegenkopplung dar und verringert die erzielbare Verstärkung (G). Im betrachteten Fall sinkt oberhalb von einer Fingerzahl von etwa 16 und einer Frequenz von etwa 1 GHz die Leistungsverstärkung G um 3 dB, wenn man die Fingerzahl verdoppelt. Als Beispiel dient der Schaltkreis der Fig. 2 mit NE=128 Emitterfingern.

Über den Eingang EIN wird dabei das hochfrequente Signal in die Schaltung zur Verstärkung eingespeist. Der Eingang EIN ist von der Basis B des Transistors Q1 durch einen Kondensator C1 gleichstrom-entkoppelt. Die Bauelemente - Stromquelle lB, Spannungsquelle V2, Transistoren Q2 und Q3, sowie die Induktivität L2- dienen der Arbeitspunkteinstellung des Hochfrequenztransistors Q1.

Der Kollektor K des Hochfrequenztransistors Q1 ist über einen weiteren Kondensator C2 mit dem Ausgang AUS der Schaltung verbunden und gleichstrommäßig entkoppelt. Weiterhin ist der Kollektor K des Hochfrequenztransistors Q1 mit einer weiteren Induktivität L1 und eine Spannungsquelle V1 wiederum zur Arbeitspunkteinstellung verbunden und hochfrequenzmäßig entkoppelt.

Der Emitter E des Hochfrequenztransistors Q1 weist einen reellen Widerstandsanteil auf, der als Widerstand angedeutet ist. Der Emitter E des Hochfrequenztransistors Q1 ist mit einem Bondpad 32 verbunden, das in dem Schaltplan der Fig. 2 schematisch als Rechteck dargestellt ist. Das Bondpad 32 ist über eine Zuleitung aus einem Bonddraht, der eine parasitäre Induktivität Lp bildet, an einem Anschluss des Gehäuses der Hochfrequenzanordnung angeschlossen.

Fig. 1 zeigt einen Anschluss des Emitters E über Bondpads 31, 32 und 33 in einer schematischen Schnittdarstellung. Auf den jeweiligen Bondpads sind Bonddrähte 51, 52, 53 mit der typischen Bondstruktur 41, 42, 43 gebondet.

Die Bondstruktur 41, 42, 43 und die Bonddrähte 51, 52, 53 wirken dabei jeweils als Induktivität. Daneben weisen sowohl die Bondstruktur 41, 42, 43 als auch die Bonddrähte 51, 52, 53 jeweils einen ohmschen Widerstand auf.

Der mittlere Bondpad 32 der in Fig. 1 dargestellten Bondpads 31, 32, 33 ist über Metallverbindungen 02, 001 und 002, die beispielsweise Aluminium aufweisen, mit dem Emitter E des Hochfrequenztransistors Q1 (siehe Fig. 2) elektrisch leitfähig verbunden, wobei die Metallverbindungen 02, 001 und 002 einen niederohmigen Widerstandswert aufweisen.

Das rechte Bondpad 31 ist von einem elektrisch leitfähigen Gebiet 11 durch ein Dielektrikum 21 getrennt. Das Dielektrikum 21 weist in diesem Ausführungsbeispiel Siliziumdioxid auf, kann aber beispielsweise auch aus Borsilikatglas gebildet sein. Das elektrisch leitfähige Gebiet 11 weist in diesem Ausführungsbeispiel ein Metall, vorzugsweise das innerhalb der Verdrahtungsebenen 001 verwendete Metall, beispielsweise Aluminium auf. Das leitfähige Gebiet 11 ist über die Metallverbindungen 01, 001 und 002 mit dem Emitter E verbunden. Selbstverständlich können auch noch weitere, in Fig. 1 nicht dargestellten, Metallverbindungen zur Verbindung notwendig sein.

Das linke Bondpad 33 ist analog zum rechten Bondpad 31 verschaltet. Im Unterschied zum rechten Bondpad 31 der Fig. 1 weist das linke Bondpad 33 eine geringere Überlappungsfläche mit einem leitfähigen Gebiet 13 auf, so dass sich ebenfalls eine Kapazität, jedoch mit abweichendem Wert ausbildet, vorausgesetzt, dass die Dielektrika 21 und 23 den Unterschied der Überlappungsflächen nicht ausgleichen. Durch unterschiedliche Kapazitäten kann bevorzugt die Herstellungstoleranz der Dielektrikumdicke ausgeglichen werden. Auch das linke leitfähige Gebiet 13 ist über Metallverbindungen 03, 001, 002 mit dem Emitter E verbunden.

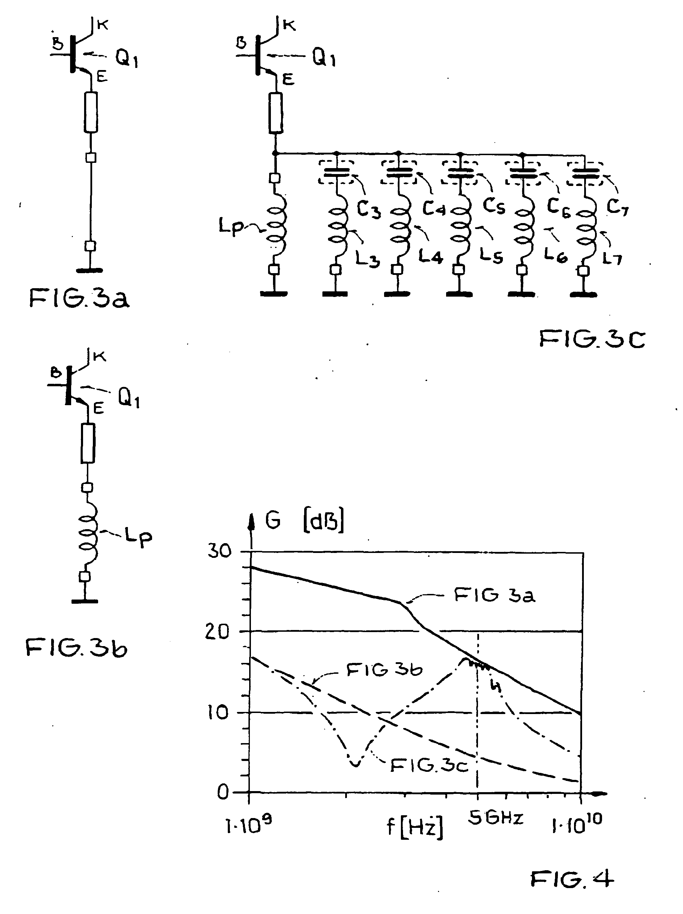

In den Figuren 3a, 3b und 3c werden unterschiedliche Arten von Anbindungen des Emitters E dargestellt. Fig. 3a zeigt die idealisierte Verbindung mit einem Bonddraht ohne Reaktanz, die nur als Vergleichswert dargestellt wird und technisch nicht zu realisieren ist. Fig. 3b zeigt die Anbindung über einen Bonddraht, der eine parasitäre Induktivität Lp von 0,1 nH ausbildet.

Ein Ausführungsbeispiel der Erfindung ist in Fig. 3c dargestellt. Während die Zuleitungsinduktivität einen Gleichstrompfad zur Versorgung der zu kontaktierenden Vorrichtung darstellt, wird durch einen ihr parallel geschalteten Serienschwingkreis die zu kontaktierende Vorrichtung bei der Resonanzfrequenz des Serienschwingkreises mit reduzierter Reaktanz bevorzugt im Wesentlichen reaktanzfrei angeschlossen.

Im Ausführungsbeispiel der Fig. 3c sind parallel zu der Bond-Induktivität Lp fünf bedämpfte Resonanzkreise aus den Kapazitäten C3, C4, C5, C6 und C7 mit den zugeordneten Induktivitäten L3, L4, L5, L6, und L7 mit jeweils geringfügig unterschiedlichen Resonanzfrequenzen von jeweils etwa 5 GHz geschaltet. Der ohmsche Widerstandanteil der Bonddrähte ist zur vereinfachten Darstellung in den Fig. 3b und 3c fortgelassen. Die Kapazitäten C3, C4, C5, C6 und C7 weisen beispielsweise einen Aufbau analog Fig. 1 auf, während die Induktivitäten Lp, L3, L4, L5, L6, und L7 durch Bonddrähte 51, 52, 53 gebildet werden.

Fig. 4 zeigt die zugehörigen erzielbaren Leistungsverstärkungen. Das Parallelschalten der genannten Resonanzkreise zu der Zuleitungsinduktivität erhöht die Leistungsverstärkung im Beispiel um mehr als eine Größenordnung. Besonders einfach lassen sich die benötigten Resonanzkreise im Beispiel durch unter den Bondpads angeordnete Kapazitäten der Flächen 80x100 µm², 90x100 µm², 100x100 µm², 110x100 µm² und 120x100 µm², sowie Siliziumoxid der Dicke 50 nm als Dielektrikum realisieren und durch so genannte Bondpags als Induktivitäten.

In Fig. 4 sind die Verstärkungen G [dB] der Schaltungsvarianten der Figuren 3a, 3b und 3c über der Frequenz f [Hz] aufgetragen. Fig. 4 zeigt, dass für das Ausführungsbeispiel der Fig. 3c die Verstärkung G an den Idealfall der Fig. 3a heranreicht, jedoch nur für die benötigte Betriebsfrequenz im Bereich von 5 GHz. Aufgrund der mehrfachen Parallelschaltung von Serienresonanzen sind im Bereich der Betriebsfrequenz von 5 GHz mehrere Maxima erzeugt, die ein breiteres Frequenzband als eine einzelne Serienresonanz hinsichtlich der Verstärkung G [dB] optimieren.

## Patentansprüche

1. Hochfrequenzanordnung mit
- einem integrierten Hochfrequenzschaltkreis,
- einem ersten Bondpad (31), der über eine erste elektrische Zuleitung (41, 51) mit einem Gehäuseanschluss und/oder einem weiteren Schaltkreis elektrisch verbunden ist,
- einem zweiten Bondpad (32), der über eine zweite Zuleitung (42, 52) mit dem Gehäuseanschluss und/oder dem weiteren Schaltkreis elektrischen verbunden ist,
wobei
- das zweite Bondpad (32) mit einem elektrisch leitfähigen Gebiet (11) leitfähig verbunden ist,
- das erste Bondpad (31) an ein Dielektrikum (21) grenzt, so dass das erste Bondpad (31) mit dem Dielektrikum (21) und dem elektrisch leitfähigen Gebiet (11) des integrierten Hochfrequenzschaltkreises eine erste Kapazität (C3, C4, C5, C6 oder C7) bildet,
- die erste Kapazität (C3, C4, C5, C6 oder C7) und die, eine Induktivität aufweisende erste Zuleitung einen Serienschwingkreis (C3 L3, C4 L4, C5 L5, C6 L6 oder C7 L7) mit einer ersten, auf eine Betriebsfrequenz des Hochfrequenzschaltkreises abgestimmten Resonanzfrequenz bilden,
- der Serienschwingkreis (C3 L3, C4 L4, C5 L5, C6 L6 oder C7 L7) der zweiten Zuleitung (42, 52) parallel geschaltet ist.

2. Hochfrequenzanordnung nach Anspruch 1, **dadurch gekennzeichnet, dass** die erste Zuleitung einen Bonddraht (51) und/oder einen Lötbump aufweist.

3. Hochfrequenzanordnung nach einem der vorhergehenden Ansprüche, **gekennzeichnet durch** ein drittes Bondpad (33), das zur Parallelschaltung über eine dritte Zuleitung (43, 53) mit dem Gehäuseanschluss und/oder dem weiteren Schaltkreis elektrischen verbunden ist,
wobei
- das dritte Bondpad (33) an ein Dielektrikum (23) grenzt, so dass das dritte Bondpad (33) mit dem Dielektrikum (23) und einem elektrisch leitfähigen Gebiet (13) des integrierten Hochfrequenzschaltkreises eine zweite Kapazität (C3, C4, C5, C6 oder C7) bildet,
- die zweite Kapazität (C3, C4, C5, C6 oder C7) und die, eine Induktivität (L3, L4, L5, L6 oder L7) aufweisende dritte Zuleitung (43, 53) einen weiteren Serienschwingkreis (C3 L3, C4 L4, C5 L5, C6 L6 oder C7 L7) mit einer zweiten Resonanzfrequenz bilden, und
- der weitere Serienschwingkreis (C3 L3, C4 L4, C5 L5, C6 L6 oder C7 L7) der zweiten Zuleitung (42, 52) parallel geschaltet ist.

4. Hochfrequenzanordnung nach Anspruch 3, **gekennzeichnet durch** weitere Parallelschaltungen von weiteren Zuleitungen und weiteren an Dielektrikum grenzende Bondpads, die weitere Serienschwingkreise (C3 L3, C4 L4, C5 L5, C6 L6 oder C7 L7) mit weiteren Resonanzfrequenzen bilden.

5. Hochfrequenzanordnung nach einem der Ansprüche 3 oder 4, **dadurch gekennzeichnet, dass** die erste Kapazität (C3, C4, C5, C6 oder C7) von der zweiten Kapazität (C3, C4, C5, C6 oder C7) durch eine unterschiedliche Geometrie, insbesondere durch einen abweichenden Flächeninhalt, verschieden ist.

6. Hochfrequenzanordnung nach einem der vorhergehenden Ansprüche, **dadurch gekennzeichnet, dass** das leitfähige Gebiet (11, 13) mit einem Halbleitergebiet eines aktiven, integrierten Bauelementes (Q1) des integrierten Hochfrequenzschaltkreises, insbesondere mit einem Emitter (E) eines Hochfrequenzbipolartransistors (Q1) oder einer Hochfrequenztetrode leitfähig verbunden ist.

7. Hochfrequenzanordnung nach Anspruch 6, **dadurch gekennzeichnet, dass** zumindest die zweite Zuleitung (42, 52) eine elektrische (Strom-)-Gegenkopplung für den integrierten Hochfrequenzschaltkreis bildet, die zumindest für die erste Resonanzfrequenz durch die Parallelschaltung des Serienschwingkreises (C3 L3, C4 L4, C5 L5, C6 L6 oder C7 L7) reduziert ist.

8. Hochfrequenzanordnung nach einem der vorhergehenden Ansprüche, **dadurch gekennzeichnet, dass** das Dielektrikum (21, 23) Siliziumdioxid aufweist und vorzugsweise eine Dicke kleiner 100nm, besonders bevorzugt 50 nm aufweist.

9. Hochfrequenzanordnung nach einem der vorhergehenden Ansprüche, **dadurch gekennzeichnet dass** das leitfähige Gebiet (11, 13) ein Metall aufweist.

10. Verwendung einer Hochfrequenzanordnung nach einem der vorhergehenden Ansprüche in einem Radarsystem oder einem Funkkommunikationssystem, insbesondere einem Mobilfunksystem.

## Claims

1. High-frequency arrangement with
- an integrated high-frequency circuit,
- a first bond pad (31), which is electrically connected with a housing connection and/or a further circuit by way of a first electrical feed (41, 51),
- a second bond pad (32), which is electrically connected with the housing connection and/or the further circuit by way of a second feed (42, 52),
whereIN
- the second bond pad (32) is conductively connected with an electrically conductive region (11),
- the first bond pad (31) adjoins a dielectric (21), so that the first bond pad (31) forms together with the dielectric (21) and the electrically conductive region (11) of the integrated high-frequency circuit a first capacitance (C3, C4, C5, C6 or C7), the first capacitance (C3, C4, C5, C6 or C7) and the first feed, which has an inductance, form a series oscillator circuit (C3 L3, C4 L4, C5 L5, C6 L6 or C7 L7) with a first resonance frequency matched to an operating frequency of the high-frequency circuit, and
- the series oscillator circuit (C3 L3, C4 L4, C5 L5, C6 L6 or C7 L7) is connected in parallel with the second feed (42, 52).

2. High-frequency arrangement according to claim 1, **characterised in that** the first feed comprises a bond wire (51) and/or a solder bump.

3. High-frequency arrangement according to one of the preceding claims, **characterised in that** a third bond pad (33), which for the connection in parallel is electrically connected by way of a third feed (43, 53) with the housing connection and/or the further circuit,
wherein
- the third bond pad (33) adjoins a dielectric (23) so that the third bond pad (33) forms together with a the dielectric (23) and an electrically conductive region (13) of the integrated high-frequency circuit a second capacitance (C3, C4, C5, C6 or C7),
- the second capacitance (C3, C4, C5, C6 or C7) and the third feed (43, 53), which has an inductance (L3, L4, L5, L6 or L7), form a further series oscillator circuit (C3 L3, C4 L4, C5 L5, C6 L6 or C7 L7) with a second resonance frequency and the further series oscillator circuit (C3 L3, C4 L4, C5 L5, C6 L6 or C7 L7) is connected in parallel with the second feed (42, 52).

4. High-frequency arrangement according to claim 3, **characterised by** further parallel connections of further feeds and further bond pads adjoining the dielectric, which form further series oscillator circuits (C3 L3, C4 L4, C5 L5, C6 L6 or C7 L7) with further resonance frequencies.

5. High-frequency arrangement according to one of claims 3 and 4, **characterised in that** the first capacitance (C3, C4, C5, C6 or C7) differs from the second capacitance (C3, C4, C5, C6 or C7) by a different geometry, particularly by a different area.

6. High-frequency arrangement according to one of the preceding claims, **characterised in that** the conductive region (11, 13) is conductively connected with a semiconductor region of an active, integrated component (Q1) of the integrated high-frequency circuit, particularly with an emitter (E) of a high-frequency bipolar transistor (Q1) or a high-frequency electrode.

7. High-frequency arrangement according to claim 6, **characterised in that** at least the second feed (42, 52) forms an electrical (current) negative feedback for the integrated high-frequency circuit, which is reduced at least for the first resonance frequency by the parallel connection of the series oscillator circuit (C3 L3, C4 L4, C5 L5, C6 L6 or C7 L7).

8. High-frequency arrangement according to one of the preceding claims, **characterised in that** the dielectric (21, 23) comprises silicon dioxide and preferably has a thickness less than 100 nm, particularly preferably 50 nm.

9. High-frequency arrangement according to one of the preceding claims, **characterised in that** the conductive region (11, 13) comprises a metal.

10. Use of a high-frequency arrangement according to one of the preceding claims in a radar system or a radio communications system, particularly a mobile radio system.

## Revendications

1. Dispositif haute fréquence comprenant:
- un circuit intégré haute fréquence,
- un premier plot de connexion (31) électriquement relié par une première ligne d'alimentation électrique (41,51) à la borne d'un boîtier et/ou à un autre circuit,
- un deuxième plot de connexion (32) électriquement relié par une deuxième ligne d'alimentation (42, 52) à la borne du boîtier et/ou à l'autre circuit,
dans lequel
- le deuxième plot de connexion (32) est relié de manière conductrice à une zone électriquement conductrice (11),
- le premier plot, de connexion (31) est contigu à un diélectrique (21), de sorte que le premier plot de connexion (31) forme avec le diélectrique (21) et la première zone électriquement conductrice (11) du circuit intégré haute fréquence une première capacité (C3, C4, C5, C6 ou C7),
- la première capacité (C3, C4, C5, C6 ou C7) et la première ligne d'alimentation présentant une inductance forment un circuit série oscillant (C3 L3, C4 L4, C5 L5, C6 L6 ou C7 L7) à une première fréquence de résonance accordée sur une fréquence de fonctionnement du circuit haute fréquence,
- le circuit série oscillant (C3 L3, C4 L4, C5 L5, C6 L6 ou C7 L7) de la deuxième ligne d'alimentation (42, 52) est monté en parallèle.

2. Dispositif haute fréquence selon la revendication 1, **caractérisé en ce que** la première ligne d'alimentation présente un fil de liaison (51) et/ou une bosse de brasage.

3. Dispositif haute fréquence selon l'une quelconque des revendications précédentes, **caractérisé par** un troisième plot de connexion (33), relié électriquement, pour le montage en parallèle, à la borne du boîtier et/ou à l'autre circuit par une troisième ligne d'alimentation (43, 53),
dans lequel
- le troisième plot de connexion (33) est contigu à un diélectrique (23), de sorte que le troisième plot de connexion (33) forme, avec le diélectrique (23) et une zone électriquement conductrice (13) du circuit intégré haute fréquence, une deuxième capacité (C3, C4, C5, C6 ou C7),
- la deuxième capacité (C3, C4, C5, C6 ou C7) et la troisième ligne d'alimentation (43, 53) présentant une inductance (L3, L4, L5, L6 ou L7) forment un autre circuit série oscillant (C3 L3, C4 L4, C5 L5, C6 L6 ou C7 L7) à une deuxième fréquence de résonance, et
- le circuit série oscillant suivant (C3 L3, C4 L4, C5 L5, C6 L6 ou C7 L7) de la deuxième ligne d'alimentation (42, 52) est monté en parallèle.

4. Dispositif haute fréquence selon la revendication 3, **caractérisé par** d'autres montages en parallèle d'autres lignes d'alimentation et d'autres plots de connexion contigus à un diélectrique, qui forment d'autres circuits série oscillants (C3 L3, C4 L4, C5 L5, C6 L6, C7 L7) à d'autres fréquences de résonance.

5. Dispositif haute fréquence selon l'une quelconque des revendications 3 ou 4, **caractérisé en ce que** la première capacité (C3, C4, C5, C6 ou C7) diffère de la deuxième capacité (C3, C4, C5, C6 ou C7) par une géométrie différente, plus particulièrement par un contenu de surface différent.

6. Dispositif haute fréquence selon l'une quelconque des revendications précédentes, **caractérisé en ce que** la zone conductrice (11, 13) est reliée de manière conductrice à une zone semiconductrice d'un composant intégré actif (Q1) du circuit intégré haute fréquence, plus particulièrement à l'émetteur (E) d'un transistor bipolaire haute fréquence (Q1) ou d'une tétrode conductrice haute fréquence.

7. Dispositif haute fréquence selon la revendication 6, **caractérisé en ce qu'**au moins la deuxième ligne d'alimentation (42, 52) forme une contre-réaction (de courant) pour le circuit intégré haute fréquence, qui est réduite au moins pour la première fréquence de résonance par le montage en parallèle du circuit intégré en série (C3 L3, C4 L4, C5 L5, C6 L6 ou C7 L7).

8. Dispositif haute fréquence selon l'une quelconque des revendications précédentes, **caractérisé en ce que** le diélectrique (21, 23) présente du dioxyde de silicium et de préférence une épaisseur inférieure à 100nm, de manière plus préférée encore 50nm.

9. Dispositif haute fréquence selon l'une quelconque des revendications précédentes, **caractérisé en ce que** la zone conductrice (11, 13) présente un métal.

10. Utilisation d'un dispositif haute fréquence selon l'une quelconque des revendications précédentes dans un système radar ou un système de communication radio, plus particulièrement un système radio mobile.
